# EUROPEAN PATENT APPLICATION

(11) **EP 3 770 956 A1**
(43) Date of publication of application: **27.01.2021**
(21) Application number: 19188406.3
(22) Date of filing: 25.07.2019
(51) Int. Cl.: H01L 23/373, H01L 23/495

(54) **POWER SEMICONDUCTOR MODULE**

(71) Applicant: ABB Schweiz AG, 5400 Baden (CH)
(72) Inventor: Schuderer, Juergen, 8047 Zürich (CH); Schroeder, Arne, 3012 Bern (CH); Pavlicek, Niko, 8041 Zürich (CH); Schneider, Daniel, 5454 Bellikon (CH)
(74) Representative: Michalski Hüttermann & Partner Patentanwälte mbB

(57) **Abstract**

The invention relates to a power semiconductor module (10), comprising a lead frame (12) for carrying an electric circuit (14), the electric circuit (14) having a plurality of power semiconductor devices (16), wherein the lead frame (12) is connected to and thermally coupled with a cooler (22) for dissipating heat from the lead frame (12) by means of a thermally conductive connecting layer (24), wherein the connecting layer (24) comprises an electrically insulating adhesive (26) wherein a plurality of spacer elements (28) is located in the adhesive (26) for defining an insulation distance between the lead frame (12) and the cooler (22)

## Description

### Technical Field

The present invention relates to a power semiconductor module. The present invention especially relates to a power semiconductor module having an improved connection of a lead frame to a cooler. The present invention further relates to a method of forming a power semiconductor module

### Background Art

Power semiconductor modules having lead frames are generally known in the art. This is an efficient and cost-saving alternative compared to power semiconductor devices having ceramic substrates, for example.

However, connecting a lead frame to a cooler being located adjacent to the lead frame in order to dissipate heat from the lead frame and thus from the chips located thereon is still an issue.

US 2011255246 A1 describes a method for manufacturing a rigid power module with a layer that is electrically insulating and conducts well thermally and has been deposited as a coating, the structure having sprayed-on particles that are fused to each other, of at least one material that is electrically insulating and conducts well thermally, having the following steps: manufacturing a one-piece lead frame; populating the lead frame with semiconductor devices, possible passive components, and bonding corresponding connections, inserting the thus populated lead frame into a compression mould so that accessibility of part areas of the lead frame is ensured, pressing a thermosetting compression moulding compound into the mould while enclosing the populated lead frame, coating the underside of the thus populated lead frame by thermal spraying in at least the electrically conducting areas and overlapping also the predominant areas of the spaces, filled with mold compound.

EP 2 261 971 A1 describes a method involving producing an integrated punched grid. The punched grid is assembled with semiconductor components, possible passive assembly parts and bonding corresponding connections. The recesses at predetermined positions remain in the envelop in the power module during enveloping. A subsequent cutting out of bars of integral punched grid takes place through the mounting die inserted in the recesses, by producing electrically insulated islands of punched grid material of the integral punched grid.

DE 10 2011 088 218 A1 describes a power module having a semiconductor chip whose lower side is provided with a metallic electrode. A copper strip conductor is formed as a thermal coupling layer and arranged on a lower side of the module. The metallic electrode is electrical conductively fixed on the conductor. A laminate comprises a thermally conductive insulation sheet formed as another thermal coupling layer for a heating element. The module lower side is fixed with the conductor on the laminate. The chip is partially embedded into a plastic mass of a plastic housing. The electronic power module has a hermetic sealed metal sheet lid for coating cooling fins and for conducting a cooling medium along the cooling fins. The semiconductor chip is designed as a metal-oxide-semiconductor power transistor or insulated-gate bipolar transistor (IGBT) transistor.

JP2008004745 describes an electronic device in which a substrate is provided with a heat generating element on the front surface and a heat sink, and the substrate is mounted on the heat sink with the back surface of the substrate facing the heat sink. The heat transfer grease intervenes in the facing distance between the back surface of the substrate and the heat sink, and the substrate and the heat sink are bonded to the outer peripheral end of the substrate.

JP 2010192591 A describes that a power semiconductor module and a cooling fin are joined by a joining member being excellent in thermal conductivity and electrical insulation, and heat generation of the semiconductor element for power can be efficiently conducted to the cooling fin. Further downsizing and capacity increase are possible. A power semiconductor module in which a cooling fin is joined to a power semiconductor device through a joining member, and an electrically insulating alumite layer is provided on a surface filled with a matrix resin. A bonding member is formed of a wire bundle of aluminium fibers having a specific structure, and the bonding surface of the cooling fin and the exposed surface of the lead frame from the sealing resin in the power semiconductor module are bonded.

JP 2012222324 A describes a semiconductor device comprising: a power module including a base plate, a power semiconductor element provided on one principal surface of the base plate, an insulation resin layer with a principal surface thereof being fixed to another principal surface of the base plate, a metal layer with one principal surface thereof being fixed to another principal surface of the insulation resin layer and a resin housing forming a housing by covering the base plate, the power semiconductor element and the insulation resin layer so as to expose another principal surface of the metal layer; and a cooler on which at least one convex stepped part is formed on one principal surface, solder bonded with an exposed surface of the metal layer at least at a top face of the convex stepped part. An area of the top face of the convex stepped part is smaller than an area of the other principal surface of the metal layer.

However, the above cited references still give room for improvements especially regarding connecting a lead frame to a cooler in a power semiconductor module.

### Summary of invention

It is therefore an object of the present invention to provide a solution for overcoming at least one disadvantage of the prior art at least in part. It is especially an object of the present invention to provide a solution for reliably connecting a lead frame to a cooler in a simple manner, thereby allowing an effective electrical insulation.

These objects are solved at least in part by a power semiconductor module having the features of independent claim 1. These objects are further solved at least in part by a method having the features of independent claim 13. Advantageous embodiments are given in the dependent claims, in the further description as well as in the figures, wherein the described embodiments can, alone or in any combination of the respective embodiments, provide a feature of the present invention unless not clearly excluded.

Described is a power semiconductor module, comprising a lead frame for carrying an electric circuit, the electric circuit having a plurality of power semiconductor devices, wherein the lead frame is connected to and thermally coupled with a cooler for dissipating heat from the lead frame by means of a thermally conductive connecting layer, wherein the connecting layer comprises an electrically insulating adhesive and wherein a plurality of spacer elements is located in the adhesive for defining an insulation distance between the lead frame and the cooler.

Such a power semiconductor module may provide significant advantages over the cited prior art, in particular with regard to connecting a lead frame to a cooler.

The power semiconductor module as described comprises a lead frame which is adapted for carrying an electric circuit having a plurality of power semiconductor devices. In detail, the lead frame is a support for carrying the electric circuit, wherein the electric circuit comprises a plurality of power semiconductor devices. With this regard, the lead frame may be formed of a copper plate which has the form of respective device areas and terminal areas which might be connected to each other by means of conducting bridges of the lead frame as such or by means of wire bonds, for example.

The device areas may be provided for placing power semiconductor devices thereon, whereas the terminal areas may be designed for placing terminals thereon. However, even more preferred, the terminal areas may form terminals themselves for example in case they are three-dimensionally shaped in the respective desired form and may be externally contacted.

Like indicated above, the power semiconductor module comprises a plurality of power semiconductor devices. Such power semiconductor devices may be generally formed as it is known in the art and may comprise, inter alia, transistors, or switches, respectively, such as MOSFETs and/or IGBTs and/or the plurality of power semiconductor devices may comprise diodes in a non-limiting manner. The power semiconductor devices may be respectively interconnected and may thus be in electrical contact, such as in galvanic contact with the respective areas of the lead frame, such as by soldering or sintering the power semiconductor devices thereon.

In order to allow gentle working conditions of the power semiconductor module and particularly of the power semiconductor devices, the lead frame is connected and thermally coupled to a cooler. The cooler thus serves for dissipating heat from the lead frame and thus from the power semiconductor devices.

The cooler may for example be formed from a base plate, which may be a plate formed from copper or aluminum, for example and may be based on fins for forced convective cooling or may be based on internal channels for liquid cooling. Especially such embodiments may provide a superb cooling behaviour and may further provide good connecting properties which might interact with a plurality of suitable adhesives.

It is provided that the lead frame is connected to the cooler by means of a connecting layer. As it is obvious for the person skilled in the art, the connecting layer is provided between the lead frame and the cooler and is preferably in contact with both of the lead frame and the cooler.

It might be preferred that only one connecting layer is provided which is connected both to the lead frame and the cooler like indicated above. However, it is further part of the present invention to provide more than one connecting layer, wherein in case more than one connecting layer are provided, these layers may be arranged in the same manner or they may be arranged differently with regard to each other.

The connecting layer and thus the at least one connecting layer should be thermally conductive which means, that the thermal conductivity is suitable for a thermal coupling of the lead frame and the cooler and for dissipating heat from the lead frame to the cooler. With this regard, the connecting layer may have a thermal conductivity lying in the range of at least 1 W/mK, wherein the upper border of the thermal conductivity may be set due to technical reasons, i.e. the materials which may be provided.

Further, the connecting layer preferably is electrically insulative.

In order to achieve this, it is further provided that the connecting layer comprises an electrically insulating adhesive wherein a plurality of spacer elements is located in the adhesive for defining an insulation distance between the lead frame and the cooler.

The electrical resistivity of the insulating adhesive and thus the matrix material of the connecting layer and preferably of the spacer elements may preferably lie in a range of more than 1E12 Ω cm, wherein the upper border of the electrical conductivity may be set due to technical reasons, i.e. the materials which may be provided.

Like indicated above, it is provided that the connecting layer comprises and preferably may be formed from, such as may consist of, an adhesive and spacer elements, wherein the adhesive and the spacer elements are electrically insulating in order to prevent an electric contact of the lead frame and the cooler. This is due to the fact that the lead frame and the cooler preferably are electrically insulate from each other in order to allow a secure and reliable working behaviour of the power semiconductor module.

With this regard, it is provided that located in the adhesive are spacer elements for defining an insulation distance between the lead frame and the cooler. The spacer elements are not fixed to the lead frame or the cooler and are thus free elements, such as free particles, which are distributed in the adhesive. In other words, the spacer elements may be formed as a filler which is distributed in the matrix material, i.e. the adhesive. The number of spacer elements may be adapted to the desired needs. In general, it is important on the one hand that enough spacer elements are available to avoid tilting of the leadframe on the cooler surface. And on the other hand, it is of advantage if there are not too many spacer elements in order to get enough cross section for adhesive bonding of the matrix to the bonding partners.

Further, the spacer elements may also have electrically insulating properties. Thus, the spacer elements may have an electrical resistivity which lies in the range as described above with regard to the adhesive.

Due to the provision of the spacer elements and thus in other words the plurality of spacer elements, a defined distance between the cooler and the lead frame may be reached. According to this, the spacer elements define a defined and reliable particularly minimum insulation distance and thus provide, next to the electrically insulating adhesive material, a defined and required electrical insulation between the lead frame and the cooler.

Due to the fact that the spacer elements are arranged as described above, the connecting layer may be formed very cost-saving, as this feature may be formed by simply adding a further component in the adhesive. This may be realized in a simple and cost-saving manner.

Apart from that, the connecting layer may be applied in a very simple manner. This may be due to the fact that the spacer elements are provided as filler in the adhesive as matrix material and may thus be applied to the lead frame or to the cooler in a simple and cost-saving manner.

Further, the provision of such a connecting layer, or adhesive, respectively, for connecting the lead frame to the cooler allows a very adaptive production of the power semiconductor module. This may be mainly due to the fact that the diameter of the spacer elements, which defines the insulation distance which is at least present, is responsible for allowing and ensuring the insulation distance like described above. This, however, allows adapting the insulation distance simply by using different spacer elements for different applications, or different power semiconductor modules, respectively.

In other words, by adapting the size of the spacer elements in the adhesive especially during the production of the adhesive, it is possible to tailor the connecting layer to the respective power semiconductor module and the respective electrical insulation requirements.

Further, a lead frame like described here is a simple and cost saving alternative to the conventional solutions of the prior art. Such prior art solutions as referred to may comprise an expensive ceramic substrate which is equipped with metallizations, which substrates are bonded or pressed to a cooler.

This approach is known for discretes, but also multi-chip power modules have been investigated. Since it is a target to have the cooler insulated for most applications, which is for example a mandatory feature for water-based cooling in electric vehicles, there is prior art either based on an insulating sheet inside the module or discrete, or by applying an insulating sheet outside of the module or discrete between module backside and cooler. Hereby, the insulating sheet is typically an epoxy laminate which is based on two prepreg or glue layers on top and bottom and an epoxy core. The laminate is applied to provide a defined insulation distance between lead frame and cooler. As an advantage, the laminate can be designed thinner than the typical limit of 300 µm of ceramic substrate insulation, its CTE is quite well matched to lead frame and cooler, but it suffers from poor thermal conductivity and also comes at significant cost, such as complex material stack, as well as requiring protection films on both sides, for example.

However, when using an adhesive like described before for connecting the lead frame and the cooler, defined and superior insulating properties may be combined with high thermal dissipation properties and further with high reliability and low costs.

It may be preferred that the spacer elements at least in part comprise a spherical form. This embodiment allows an especially simple and reliable application of the adhesive together with the spacer elements. In fact, when applying the adhesive onto at least one of the lead frame and the cooler, an alignment, or an orientation, respectively, of the spacer elements is not required. In contrast thereto, independently from the orientation of the spacer elements, they provide the same insulation distance between the lead frame and the cooler. Thus, conventional application methods may be used. This further simplifies the process of production of such a power semiconductor module and further allows an especially high reliability of very defined insulation properties, which in turn allows that the working behaviour of the power semiconductor module is especially reliable and safe.

With regard to the diameter of the spacer elements, it may be provided that the diameter is adapted to the working behaviour pf the power semiconductor module and in particular to the required insulation distance. As a non-limiting example, it may be provided that the preferably spherical spacer elements have a diameter in the range of 50 - 200 µm.

It may further be provided that the spacer elements in a huge amount have the same diameter. In other words, it may be provided that at least 90 weight% of the spacer elements have the same diameter and especially a diameter as described above. This allows homogeneous properties of the connection layer and further a uniform insulation distance leading to an especially reliable and safe working behaviour of the power semiconductor module.

It may further be provided the plurality of spacer elements comprises a material selected from the group consisting of silicon dioxide, aluminum oxide, aluminum nitride, silicon nitride, glass, berylia, boron nitride. Especially preferred, the spacer elements are formed from silicon dioxide.

It was found that especially in case the spacer elements are formed from a material as described above, they have electrically insulating properties which are very well suitable for the desired application. However, these materials not only have the required electrically insulation behaviour but also are stable at the conditions appearing in case a power module works and further have a stability which is suitable for the production process of the power semiconductor module and particularly for connecting the cooler and the lead frame by using the connecting layer during working conditions. Thus, especially this embodiment may provide a reliable electric insulation between the cooler and the lead frame.

It may further be provided that the insulation distance between the lead frame and the cooler is defined by the diameter of the plurality of spacer elements. According to this embodiment, the distance between the lead frame and the cooler corresponds to the diameter of the spacer elements. However, due to technical reasons this embodiment may comprise that a thin layer of adhesive is located between the lead frame and the spacer elements and between the cooler and the spacer elements. Therefore, it may be provided that distance between the lead frame and the cooler is the same compared to the diameter of the spacer elements together with a small spacer caping distance of less than 10 µm. According to this embodiment, it is thus avoided that a thick layer of adhesive such as thicker than 10 µm is located between each spacer element and the lead frame on the one side and the cooler on the other side.

Generally, it may be provided that the adhesive and thus the matrix material of the connection layer may be formed by any one of thermosetting epoxy resin, polyester resin, acrylic resin, urethane resin, silicone resin and the like.

However, it may be preferred that the adhesive comprises such as consists of a silicone resin. A silicone resin may provide significant advantages. In particular and for example compared to an epoxy resin, a silicone adhesive may be beneficial in terms of stress relaxation between the joining partners. This may inter alia be possible due to an elastic behaviour of the silicon resin. Thus, using a silicon resin as adhesive and thus especially as a matrix material for the connection layer may provide an especially high reliability and long-term stability.

Alternatively, it may further be provided that the adhesive comprises such as consists of an epoxy resin. In case an epoxy resin is used as adhesive and thus as matrix material for the connection layer, an advantage may be seen in that epoxy resins are preferable in terms of adhesion strength. Therefore, an epoxy resin may provide a very stable connection of the lead frame and the cooler and may further provide an especially high long-term reliability, as an epoxy resin provides especially well adhesive properties with regard to metals, ceramics, silicon and polymeric materials. Further a good resistance against water and chemicals may be reached.

It may further be provided that the power semiconductor module is a transfer molded-module. According to this embodiment, significant synergistic effects may be reached.

With this regard, transfer-molded power semiconductor modules have become an interesting alternative to the traditional gel or resin encapsulation approach due to benefits with respect to costs, as no housing is required, due to cycle reliability as it is possible to provide hard mold and low-CTE encapsulation of the power semiconductor devices and respective connections, due to environmental protection as low moisture absorption and vapor diffusion is reached, and further due to vibration, shock and handling properties as well as warpage reduction. Thus, transfer molded modules have significant advantages over solutions of the prior art.

Regarding the prior art, different concepts exist for the mold module's internal insulation and attachment to a cooler structure.

As a first approach according to the prior art, the mold module can be based on a ceramic substrate that provides the insulation to the cooler or baseplate. Compared to this approach, the present invention is superior with regard to costs, such as due to omitting the ceramic substrate, and is further superior with regard to producability.

It may further be provided that the power semiconductor module is a three-phase module. Again, this embodiment may show the advantages as described especially effectively, as especially with regard to three-phase modules the connection of a lead frame to a cooler was an issue according to the prior art.

With regard to three-phase modules, the following may be noted.

In two-level traction inverters driving a three-phase machine, six functional semiconductor switches are needed. When looking at traction inverters for electric vehicles, for example, the state-of-the-art often comprises a six-pack module integrating three individual phases in a common baseplate or cooler. A typical module of this design is based on a 3-phase pin-fin baseplate, a plastic frame glued to the baseplate and a silicone gel encapsulation. The module itself is screwed on an open cooler or housing and is sealed by an O-ring. In addition to this design, there is the trend in automotive industry away from screwed O-rings towards closed coolers being already part of the power module. Also for this approach, multiple substrates are assembled on a single cooler and then encapsulated by a gel or resin that is potted into a frame.

When thinking about a transfer-molded three-phase module, overmolding of an entire three-phase baseplate or cooler gets difficult for the following reasons.

Curing of the epoxy material during compound transfer limits the possible length of a molding channel (typical gelation time: 30s). The mold compound loading volume in commercial equipment is limited, e.g. to 150 g only. Further, there mostly is a CTE mismatch between the mold compound, the ceramic substrates and large-scale cooler / baseplate can lead to warpage and stress that might impact the mechanical integrity and lead to mold compound delamination.

It is thus preferred to realize a three-phase mold module based on three individual mold modules and thus one half-bridge module per phase. In consequence, the mold modules need to be attached to the cooler system after being molded.

The following methods are known from prior art.

Modules are screwed or mechanically clamped. A disadvantage of this approach is the requirement of screws & space for screw holes or clamping structures in the modules or inverter. An additional issue is the need for an O-ring type sealing which has disadvantages with regard to seal reliability and automation.

Further, it is known that modules are metallurgically bonded to the cooler e.g. by means of soldering, sintering, or welding. A problem of these approaches may be seen in the fact that the mold modules need to undergo a high-temperature bonding process that can lead to issues of mold compound delamination.

Alternatively, it is known that modules are adhesively bonded to the cooler. Known prior art for power module adhesives is epoxy lamination with glass fibers. As discussed above, disadvantages are relatively high cost due to an indicative offer for 100 µm epoxy laminate being the same as twenty times of silicone glue of the same volume, and a rather low thermal conductivity of the laminate, typically significantly less than 1 W/mK. Whereas typically available laminates are restricted to low thermal conductivity glass-fibre inlays, the glue-dispense approach according to the present invention allows flexible selection of higher thermal-conductivity fillers like described below. In addition, the glue dispense process has several advantages over lamination: It is a low-temperature process, e.g., a glue matrix can be selected that cures at room temperature, and it is low-pressure process, i.e., it just requires some minor pressure to establish the contact between the bonding partners and does not need pressures of up to 20 MPa as recommended for Epoxy laminates. When using a power semiconductor module as described above, these advantages may be overcome at least in part.

Therefore, especially when thinking about the above, the present inventions shows significant advantages when thinking about connecting a baseplate to a cooler when referring to three-phase modules.

It may further be provided that the adhesive comprises a thermally conductive filler. When using a thermally conductive filler, it may be reached that the thermal conductivity is further improved so that the cooling behaviour of the cooler as well may further be improved. Thus, the working behaviour may be especially reliable and safe and the module may work with an especially high performance. Further the long-term stability and reliability of the power semiconductor module may further be improved.

Thus, a thermally conductive filler in the sense of the present invention particularly is such a filler which has a thermal conductivity which is better compared to the thermal conductivity of the adhesive and preferably of the spacer elements.

With this regard, it may be provided that the thermally conductive filer comprises a material selected from the group consisting of aluminum oxide, aluminum nitride, silicon nitride, silicon carbide, berylia, boron nitride. Especially such materials may provide a high thermal conductivity and may further be stable at the working conditions of the power module and further at the conditions arising when connecting the lead frame to the cooler.

Although the thermally conductive filler may under circumstances comprise a comparable material as compared to the spacer elements, these compounds may well be differentiated with regard to each other. For example, the size of the respective fillers significantly differs.

In fact, the thermally conductive filler has a diameter which is significantly lower compared to the spacer elements which may lie in the range as defined above. Thus, whereas the spacer elements are provided for providing a distance between the lead frame and the cooler, the thermally conductive filler are spread in the connecting layer.

The thermally conductive filler preferably has a diameter in the range of ≤ 10 µm, particularly in the range of ≥ 0,1 µm to ≤ 10 µm, wherein the diameter is the biggest diameter of the particles in case they are not present in a spherical form. The limited size of the thermally conductive filler leads to the advantage of an improved mechanical properties and to an improved dispersion of the filler in the matrix.

With regard to further advantages and technical features of the power semiconductor module, it is referred to the method, the figures and the further description.

Further describes is a method of forming a power semiconductor module, comprising steps of:
a) providing a semi-finished product of the power semiconductor module, wherein the semi-finished product comprises a lead frame which preferably carries an electric circuit having a plurality of power semiconductor devices; and
b) fixing the lead frame to a cooler for dissipating heat from the lead frame by means of a thermally conductive connecting layer such, that the lead frame is connected to and thermally coupled with the cooler;
   wherein
c) the connecting layer comprises an electrically insulating adhesive wherein a plurality of spacer elements is located in the adhesive for defining an insulation distance between the lead frame and the cooler.

Such a method is suited for producing a power semiconductor module as described before and is thus suited for forming, or producing, respectively, a power semiconductor module which provides the advantages as described before.

In order to achieve this, the method comprises the following steps.

According to method step a) it is provided to provide a semi-finished product of the power semiconductor module, wherein the semi-finished product comprises a lead frame which optionally carries an electric circuit having a plurality of power semiconductor devices.

With regard to the arrangement of the lead frame and the electric circuit it is referred to the above description. Generally, such a semi-finished product may be formed as it is known from the prior art. As an example, the electric circuit may be arranged for forming a three-phase module. However, it is also possible that the electric circuit is not yet attached to the lead frame and thus the semi-finished product may only comprise the lead frame.

According to method step b) it is further provided to fix the lead frame to a cooler for dissipating heat from the lead frame by means of a thermally conductive connecting layer such, that the lead frame is connected to and thermally coupled with the cooler. This allows to mechanically connect and thermally couple the lead frame to the cooler. As a result, a reliable connection from the lead frame and the cooler is reached and further an effective cooling behaviour of the lead frame is possible.

With regard to step c), it is further provided that the connecting layer comprises an electrically insulating adhesive wherein a plurality of spacer elements is located in the adhesive for defining an insulation distance between the lead frame and the cooler. It may be provided that the insulating adhesive is applied by a simple dispense and attach process that does not require any significant temperature or pressure loading during manufacture.

Especially this feature leads to the advantages as described before, and thus especially to a defined electric insulation and a superb producability.

The method may thus be performed in a very easy manner.

With this regard, it may be provided that that step a) comprises the steps of
a1) sintering or soldering of the power semiconductor devices to the lead frame;
a2) wire bonding for electrically connecting the power semiconductor devices;
a3) transfer molding for encapsulating the power semiconductor devices, and
a4) triming and forming the lead frame.

Thus, firstly, the power semiconductor devices are bonded to the lead frame and are thus mechanically as well as electrically connected to the lead frame.

Afterwards, wire bonds may be connected to the power semiconductor devices and further positions of the lead frame for electrically connecting the power semiconductor devices.

Having attached the power semiconductor devices to the lead frame and having electrically connected them, the method may comprise, independently of the specific embodiment, the step of transfer molding in order to encapsulate the power semiconductor devices in a respective mold, such as in an epoxy mold.

After having performed the step of transfer molding, the lead frame may be trimmed and formed and may thus be brought into the desired geometry and thus three-dimensional form and size. Thus, for example, areas which should act as terminals are bent so that they are very well externally connectable. Further, respective electrically connecting structures may be formed.

As a next step, the semi-finished product as provided like described before is glued to a cooler by providing an adhesive, e.g., by dispensing, in which spacer elements are provided for defining a minimum distance between the cooler and the lead frame like described in more detail above.

General advantages of gluing the arrangement to a cooler may be seen in a low thermal impact and a high flexibility in respective producing steps which may e.g. allow automated processes in a wide range.

Further, such a step may realize especially low costs.

In order to allow an especially stable connection, it may be provided that the surfaces which shall be connected by the adhesive are pretreated, such as by using a plasma. This allows realizing surfaces which allow especially effective adhesive properties.

The adhesive preferably together with the spacer elements being distributed in the adhesive may be applied according to generally known methods especially, in case the adhesive is a liquid adhesive, for example. Exemplary steps for applying the adhesive to the lead frame and/or the cooler may comprise transferring the adhesive from a tool, such as a roller, by dispensing the adhesive, or the like, without being limited to these examples. This may be realized, for example, by providing dots, lines and the like, of the adhesive, or glue, respectively.

With regard to further advantages and technical features of the method, it is referred to the power semiconductor module, the figures and the further description

### Brief description of drawings

These and other aspects of the invention will be apparent from and elucidated with reference to the embodiments described hereinafter. Individual features disclosed in the embodiments con constitute alone or in combination an aspect of the present invention. Features of the different embodiments can be carried over from one embodiment to another embodiment.

In the drawings:
Fig. 1 shows a first embodiment of a power semiconductor module according to the present invention; and
Fig. 2 shows a further embodiment of a power semiconductor module according to the present invention.

### Description of embodiments

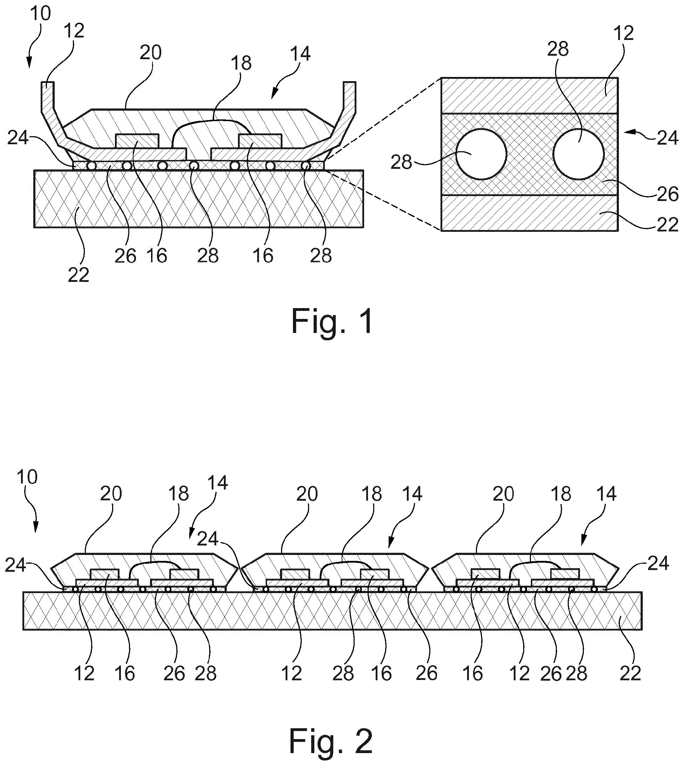

Fig. 1 shows an embodiment of a power semiconductor module 10 according to the present invention.

The power semiconductor module 10 comprises a lead frame 12 for carrying an electric circuit 14, the electric circuit 14 having a plurality of power semiconductor devices 16, wherein two of the power semiconductor devices 16 are shown in figure 1.

The power semiconductor devices 16 are electrically connected to each other via a wire bond interconnection 18. Apart from that, it is shown that the power semiconductor module 10 is a transfer molded module. Therefore, the power semiconductor devices 16 are encapsulated in a mold compound 20, such as in an epoxy mold compound.

It is further shown that the lead frame 12 is connected to and thermally coupled with a cooler 22 for dissipating heat from the lead frame 12 by means of a connecting layer 24. With regard to the connecting layer 24, it is provided that the connecting layer 24 comprises an electrically insulating adhesive 26, which acts as a matrix material. The adhesive 26 may be formed from an epoxy resin or a silicone resin, for example. Further, a plurality of spacer elements 28 is located in the adhesive 26 for defining an insulation distance between the lead frame 12 and the cooler 22.

The spacer elements 28 ensure a defined insulation distance between the lead frame 12 and the cooler 22 and thus ensure a reliable and stable working behaviour of the power semiconductor module 10.

With regard to the spacer elements 28 and according to the embodiment of figure 1, it is provided that the spacer elements 28 have a spherical form and are formed from a material selected from the list consisting of silicon dioxide, aluminum oxide, aluminum nitride, silicon nitride, glass, berylia, boron nitride. However, generally further materials are also possible.

Such a power semiconductor module 10 provides significant advantages, such as over conventional power semiconductor modules10 having a ceramic substrate and comprising a housing filled with a gel.

In fact, it may be achieved that package material cost and manufacturing cost are reduced to a minimum: The top-three cost driver in conventional power module packages are the ceramic substrate, the housing including embedded terminals, and the baseplate or cooler, respectively. All of these cost factors are minimized or eliminated by the present approach. The ceramic substrate is exchanged with a low-cost lead frame 12 such as of copper that incorporates already all terminals as a single-piece chip carrier. The module housing is eliminated by the mold compound, and the expensive copper baseplate or cooler 22 may be replaced with a low-cost aluminum cooler 22. Manufacturing is also very simple and can be fully automated by using the following steps, for example: 1) Sintering of chips and other on-board components onto the lead frame 12; 2) Wire bonding of electrical connections to the chips, or power semiconductor devices 16, respectively; 3) transfer molding; 4) trimming and forming of the lead frame 12; and 5) adhesive bonding of mold modules to a cooler 22.

Further, next to the option for a low-cost aluminum cooler 22, improved system reliability may be reached. In an exemplary embodiment, an epoxy mold 20 compound and a copper lead frame 12 have a matched coefficient of thermal expansion that is very close to aluminum (CTE Cu: 16 ppm/K vs. Al: 22 ppm/K). Therefore, the stresses on the lead frame 12 to cooler bond interface are significantly smaller than for any ceramic substrate (Si₃N₄: 3.5 ppm/K, Al₂O₃: 7 ppm/K).

Apart from the above, it is possible that low-cost standard mold compounds are applicable that do not need to withstand a high-temperature bonding process to the cooler, e.g., as would be required for a cooler bonding process based on soldering, sintering or lamination. The mold module attachment to the cooler 22 is based on dispensing of adhesive 26, mold module placement, and adhesive curing. Since the adhesive curing process is conducted at low-temperature, e.g., in the range of room temperature to 60°C, there is no risk for mold compound delamination as it would be present for soldering, sintering or welding, where the glass transition temperature of any epoxy-based mold compound is exceeded.

On the right hand side of figure 1, the arrangement of the connecting layer 24 between the lead frame 12 and the cooler 22 is shown in more detail.

Figure 2 shows a further embodiment of a power semiconductor module 10 according to the invention. According to figure 2, the description of figure 1 is completely transferable to figure 2. However, according to figure 2, a three-phase power semiconductor module 10 according to the invention is shown. The three phase module may for example include power semiconductor devices 16 and cooler 22 for a design to reach the properties of e.g. 450 V, and 600A power module ratings (fs = 10 kHz), these values however not being limiting to the present invention.

According to figure 2, the three-phase power semiconductor module 10 comprises one common cooler 22 for all half bridge modules.

This invention thus specifically and in an embodiment deals with the problem to unite transfer-molded half-bridge power modules with the requirement for a compact three-phase power module on a closed cooler 22. In addition, this invention targets to reduce package-level costs of e.g. automotive power modules to a minimum. At the same time it is the goal to improve passive cycling reliability for the substrate to cooler interface to such a level, that the required capability of at least 1000 cycles in a range of -40 to 125°C can be achieved even when a applying a low-cost aluminum cooler 22 instead of a copper cooler 22.

It is the idea of this invention to protect a compact, screw- and O-ring less three-phase power module 10 that is based on transfer molded half-bridge modules with chips bonded, preferably sintered, on a copper lead frame 12 chip carrier instead of a metallized ceramic substrate, and an electrically-insulating adhesive bond material between half-bridge module lead frame 12 and cooler 22, whereby particularly spherical filler materials or spacer elements 28 are incorporated into the adhesive 16 that act as bond spacers to provide the required insulation distance.

While the invention has been illustrated and described in detail in the drawings and foregoing description, such illustration and description are to be considered illustrative or exemplary and not restrictive; the invention is not limited to the disclosed embodiments. Other variations to be disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting scope.

### Reference signs list

- 10: power semiconductor module
- 12: lead frame
- 14: electric circuit
- 16: power semiconductor device
- 18: interconnection
- 20: mold compound
- 22: cooler
- 24: connecting layer
- 26: adhesive
- 28: spacer element

## Claims

1. A power semiconductor module (10), comprising a lead frame (12) for carrying an electric circuit (14), the electric circuit (14) having a plurality of power semiconductor devices (16), wherein the lead frame (12) is connected to and thermally coupled with a cooler (22) for dissipating heat from the lead frame (12) by means of a thermally conductive connecting layer (24), **characterized in that** the connecting layer (24) comprises an electrically insulating adhesive (26) wherein a plurality of spacer elements (28) is located in the adhesive (26) for defining an insulation distance between the lead frame (12) and the cooler (22).

2. The power semiconductor module (10) according to claim 1, **characterized in that** the plurality of spacer elements (28) at least in part comprises a spherical form.

3. The power semiconductor module (10) according to any of claims 1 or 2, **characterized in that** the plurality of spacer elements (28) comprises a material selected from the group consisting of silicon dioxide, aluminum oxide, aluminum nitride, silicon nitride, glass, berylia, and boron nitride.

4. The power semiconductor module (10) according to any of claims 1 to 3, **characterized in that** the insulation distance between the lead frame (12) and the cooler (22) is defined by the diameter of the plurality of spacer elements (28).

5. The power semiconductor module (10) according to any of claims 1 to 4, **characterized in that** the adhesive (26) comprises a silicone resin.

6. The power semiconductor module (10) according to any of claims 1 to 5, **characterized in that** the adhesive (26) comprises an epoxy resin.

7. The power semiconductor module (10) according to any of claims 1 to 6, **characterized in that** the plurality of spacer elements (28) has a diameter in the range of ≥ 50 µm to ≤ 200 µm.

8. The power semiconductor module (10) according to any of claims 1 to 7, **characterized in that** the cooler (22) comprises a plate formed from aluminum.

9. The power semiconductor module (10) according to claim 1 to 8, **characterized in that** the power semiconductor module (10) is a transfer-molded module.

10. The power semiconductor module (10) according to any of claims 1 to 9, **characterized in that** the power semiconductor module (10) is a three-phase module.

11. The power semiconductor module (10) according to any of claims 1 to 10, **characterized in that** the adhesive (16) comprises a thermally conductive filler.

12. The power semiconductor module (10) according to claim 11, **characterized in that** the thermally conductive filler comprises a material selected from the group consisting of aluminum oxide, aluminum nitride, silicon nitride, silicon carbide, berylia, and boron nitride.

13. A method of forming a power semiconductor module (10), comprising steps of:
a) providing a semi-finished product of the power semiconductor module (10), wherein the semi-finished product comprises a lead frame (12) which preferably carries an electric circuit (14) having a plurality of power semiconductor devices (16); and
b) fixing the lead frame (12) to a cooler (22) for dissipating heat from the lead frame (12) by means of a thermally conductive connecting layer (24) such, that the lead frame (12) is connected to and thermally coupled with the cooler (22); wherein
c) the connecting layer (24) comprises an electrically insulating adhesive (16) wherein a plurality of spacer elements (28) is located in the adhesive (26) for defining an insulation distance between the lead frame (12) and the cooler (22).

14. The method according to claim 13, **characterized in that** the method comprises the step of transfer molding.

15. The method according to claim 14, **characterized in that** step a) comprises the steps of
a1) sintering or soldering of the power semiconductor devices (16) to the lead frame (12);
a2) electrically connecting the power semiconductor devices (16) by wire bonding;
a3) encapsulating the power semiconductor devices (16) by transfer molding, and
a4) trimming and forming the lead frame (12).
